(19) Europäisches Patentamt / European Patent Office / Office européen des brevets

(11) **EP 1 914 785 B1**

(12) **EUROPEAN PATENT SPECIFICATION**

(45) Date of publication and mention
of the grant of the patent:
**14.09.2016 Bulletin 2016/37**

(51) Int Cl.:
*H01J 37/153* (2006.01)

(21) Application number: **07254102.2**

(22) Date of filing: **17.10.2007**

(54) **Aberration corrector and method of aberration correction**

Aberrationskorrektor und Verfahren für Aberrationskorrektur

Correcteur d'aberrations et procédé pour la correction d'aberrations

(84) Designated Contracting States:
**DE NL**

(30) Priority: **20.10.2006 JP 2006287009**

(43) Date of publication of application:
**23.04.2008 Bulletin 2008/17**

(73) Proprietor: **JEOL LTD.**
**Akishima,**
**Tokyo 196-8558 (JP)**

(72) Inventors:
• **Sawada, Hidetaka**
**Tokyo 190-0004 (JP)**
• **Hosokawa, Fumio**
**Tokyo 196-0012 (JP)**

(74) Representative: **Boult Wade Tennant**
**Verulam Gardens**
**70 Gray's Inn Road**
**London WC1X 8BT (GB)**

(56) References cited:
**JP-A- 2005 353 429      US-A- 4 962 313**
**US-A1- 2004 036 030**

• **HAIDER M ET AL: "DESIGN AND TEST OF AN ELECTRIC AND MAGNETIC DODECAPOLE LENS//BAU UND ERPROBUNG EINER ELEKTRISCH-MAGNETISCHEN ZWOELFPOLLINSE", OPTIK, JENA, DE, vol. 63, no. 1, 1 January 1982 (1982-01-01), pages 9-23, XP008051532, ISSN: 0863-0259**

**Description**

BACKGROUND OF THE INVENTION

1. Field of the Invention

The present invention relates to an aberration corrector and a method of aberration correction and, more particularly, to aberration corrector and method of aberration correction for correcting chromatic aberration in the whole system created by an objective lens or a condenser lens.

2. Description of the Related Art

Spherical aberration is one factor causing a deterioration of the resolution in an electron beam system such as a transmission electron microscope (TEM) or scanning electron microscope (SEM). If it is possible to correct the chromatic aberration, the resolution will be improved. In a high-resolution electron microscope such as a transmission electron microscope, it is necessary to correct chromatic aberration in the whole system created by the objective lens or condenser lens.

In non-patent reference 1 described below, a technique regarding correction of chromatic aberration utilizing a combination of magnetic and electric quadrupole elements is described. This is a method presently used in scanning electron microscopy (SEM). A deflecting force created by an electrostatic quadrupole element varies linearly in proportion to the angle (position within a multipole element). Also, in the case of a magnetic quadrupole element, the deflecting force varies linearly in proportion to the angle and, therefore, the trajectory of the electron beam can be kept unchanged by causing one side of the quadrupole element to contribute in the direction of divergence from the optical axis and causing the other side to contribute in the converse direction. On the other hand, the refractive index (dependence of the deflecting force on wavelength or dependence of the deflecting force on accelerating voltage) of the electron beam relative to an electric field is different from that of the refractive index of the beam relative to a magnetic field. Therefore, the refractive index can be varied on its own without varying the trajectory by combining electric and magnetic fields. Chromatic aberration can be corrected by setting the refractive index created by the combination of magnetic and electric quadrupole elements in such a way as to cancel out the refractive index of the objective lens.

In this method, chromatic aberration correction can be made only in the x-direction or only in the y-direction. Generally, therefore, two correction systems are prepared to correct chromatic aberration in both directions.

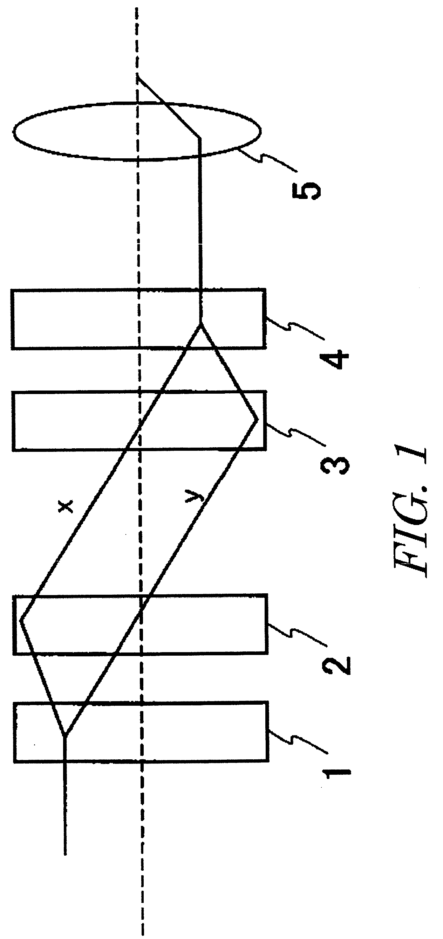

Fig. 1 shows an example of an optical system for correction of chromatic aberration, the optical system utilizing a combination of magnetic and electrostatic quadrupole elements. This optical system corrects chromatic aberration produced in an objective lens (OL) 5. In this optical system, chromatic aberration correction can be made only in the x-direction. Therefore, a magnetic quadrupole element 1 for bringing the beam to a line focus is necessary. A combination of magnetic and electric quadrupole elements 2 superimposes magnetic and electric fields at the plane where the line focus has been achieved by the magnetic quadrupole element 1. Thus, chromatic aberration correction is made in the x-direction. Then, chromatic aberration in the y-direction is corrected by a combination of magnetic and electric quadrupole elements 3. Finally, a quadrupole element 4 is placed between the combination of magnetic and electric quadrupole elements 3 and the objective lens 5 to return the beam to a round form from the state of the line focus.

[Patent reference 1] Japanese Patent Laid-Open No. 2003-203593

[Non-patent reference 1] O. Scherzer, Optik 2, 114-132 (1947)

The optical system of Fig. 1 for aberration correction is intended to correct chromatic aberration in the objective lens 5 used in SEM. Therefore, the optical system assumes that the electron beam incident on the magnetic quadrupole element 1 has been sharply focused. In the case of a transmission electron microscope, when chromatic aberration in the illumination system should be corrected in the scanning mode (STEM mode), the method used in SEM can be employed in principle. However, in the transmission mode (TEM mode), it is necessary to correct chromatic aberration by a method different from the method used in SEM for the following reason. In SEM or STEM mode, a sharply focused electron beam is made to hit a specimen and so it suffices to make chromatic aberration correction only regarding the electron beam close to the focal point. However, in the TEM mode, the electron beam hitting the specimen has spread and so the same correction of aberration is necessary for the whole field of view having spread. Consequently, chromatic aberration correction cannot be made with the optical system for SEM aberration correction as shown in Fig. 1. For this reason, chromatic aberration has not been corrected up to now either in STEM mode or in TEM mode of the transmission electron microscope.

JP2005 353429A discloses a chromatic aberration correction device that creates negative chromatic aberration by superposing quadrupole fields from electro-optic devices.

## SUMMARY OF THE INVENTION

In view of the foregoing circumstances, the present invention has been made. It would be desirable to provide an aberration corrector which is capable of correcting chromatic aberration in a lens disposed in the direction of motion of an electron beam using a relatively simple correction system and which achieves high-resolution imaging in a high-resolution electron microscope such as a transmission electron microscope. It would be further desirable to provide a method of aberration correction implemented by this aberration corrector. It would be still further desirable to provide chromatic aberration corrector and method of chromatic aberration correction.

An aberration corrector according to the present invention corrects aberration produced in a lens disposed in the direction of motion of an electron beam which is cylindrically symmetrical and which has spread. The corrector has a first quadrupole field-producing multipole element on which the electron beam not yet corrected for the aberration impinges and a second quadrupole field-producing multipole element from which the aberration-corrected electron beam exits.

The first and second quadrupole field-producing multipole elements produce first and second quadrupole fields, respectively. The first and second quadrupole fields create optical systems each having a two-fold astigmatic effect of a primary term and a focusing effect in the direction of divergence of a cylindrically symmetrical type, i.e. a concave lens effect having cylindrical symmetry.

As the length of each of the first and second quadrupole fields in the direction of motion of the electron beam is increased, the intensity of the primary term increases. The focusing effect in the direction of divergence of the cylindrically symmetrical type is caused by higher-order terms of the quadrupole field having magnitudes increasing at higher rates than the primary term when the length is increased.

The two-fold astigmatic effects of the first and second quadrupole fields for the cylindrically symmetrical electron beam having the spread are substantially canceled out by setting the first and second quadrupole fields to mutually opposite polarities. Only the focusing effect in the direction of divergence of the cylindrically symmetrical type is used for correction of the aberration in the lens.

An aberration corrector according to one embodiment of the present invention causes the aforementioned quadrupole field-producing multipole elements to produce the quadrupole fields having higher-order terms, previously finds the relationship between the magnitude of the focusing effect in the direction of divergence of the cylindrically symmetrical type caused by the higher-order terms of each quadrupole field and the length of the quadrupole field in the direction of motion of the electron beam, and determines the length of the quadrupole field in the direction of motion of the electron beam necessary to correct the aberration in the lens using the relationship and based on the magnitude of the effect necessary to correct the aberration.

In another embodiment of the aberration corrector, the aberration in the lens corrected by the combination of the first and second quadrupole field-producing multipole elements is chromatic aberration.

In a further embodiment of the aberration corrector, the quadrupole fields having lengths in the direction of motion of the electron beam are produced by the quadrupole field-producing multipole elements. Optical systems which have focusing effects in the direction of divergence of the cylindrically symmetrical type and which are different in refractive index from the lens are created. Thus, the lens is corrected for chromatic aberration.

In a yet other feature of the aberration corrector, the quadrupole fields having lengths in the direction of motion of the electron beam are produced by the quadrupole field-producing multipole elements. Optical systems having focusing effects in the direction of divergence of the cylindrically symmetrical type are created. If the optical systems and the lens are identical in refractive index, the lens is corrected for chromatic aberration by making use of the fact that the absolute value of a negative amount of chromatic aberration of the optical system is greater than the amount of chromatic aberration in the lens.

In a still further embodiment of the aberration corrector, the quadrupole fields produced by the quadrupole field-producing multipole elements are any one of electrostatic quadrupole fields, magnetic quadrupole fields, or quadrupole fields in each of which electrostatic and magnetic quadrupole fields have been superimposed.

In an additional embodiment of the aberration corrector, a pair of transfer lenses is disposed between the first and second quadrupole field-producing multipole elements.

In a yet other embodiment of the aberration corrector, the quadrupole fields produced respectively by the first and second quadrupole field-producing multipole elements are different from each other in length taken in the direction of motion of the electron beam.

In an additional embodiment of the aberration corrector, each of the quadrupole field-producing multipole elements acts to produce an electrostatic or electric two-fold field by superimposing a quadrupole field onto a hexapole element using an electrostatic field or a magnetic field or both.

In an additional embodiment of the aberration corrector, each of the quadrupole field-producing multipole elements acts to produce an electrostatic or electric two-fold field by superimposing a quadrupole field onto a dodecapole (12-pole) element using an electrostatic or a magnetic field or both.

In an additional embodiment of the aberration corrector, each of the quadrupole field-producing multipole elements acts to produce an electrostatic or electric two-fold field by superimposing a quadrupole field onto an octopole element using an electrostatic or a magnetic field or both.

In an additional embodiment of the aberration corrector, a pair of transfer lenses is disposed between the second quadrupole field-producing multipole elements and the objective lens.

The present invention also provides a method of correcting aberration produced in a lens disposed in the direction of motion of an electron beam. This method starts with causing each quadrupole field-producing multipole element to produce a two-fold astigmatic effect and a focusing effect in the direction of divergence of the cylindrically symmetrical type, i.e. a concave lens effect having cylindrical symmetry.

As the length of each quadrupole field taken in the direction of motion of the electron beam is increased, the magnitude of the two-fold astigmatic effect is increased. The focusing effect is produced by higher-order terms of the quadrupole field. The two quadrupole fields are combined to substantially cancel out two-fold astigmatic effects of the first and second quadrupole fields. Only the focusing effect in the direction of divergence of the cylindrically symmetrical type is used to correct the aberration in the lens for the cylindrically symmetrical electron beam having spread.

The description so far is provided while taking account of the illumination system for forming a probe to be directed to the specimen. In the imaging system for creating an image, chromatic aberration can be similarly corrected.

According to the embodiments of the present invention, a lens disposed in the direction of motion of an electron beam can be corrected for chromatic aberration with a relatively simple correction system even where the beam is of the cylindrically symmetrical type and has spread. Therefore, high-resolution imaging can be accomplished in a high-resolution electron microscope such as a transmission electron microscope.

Other preferred embodiments of the invention will appear in the course of the description thereof, which follows.

BRIEF DESCRIPTION OF THE DRAWINGS

Fig. 1 is a diagram illustrating a conventional method of correcting chromatic aberration by the use of a combination of magnetic and electric quadrupole elements.

Fig. 2 is a diagram showing the structure of a transmission electron microscope having an illumination system equipped with an aberration corrector.

Fig. 3 is a diagram showing an example of structure of the optical system of a chromatic aberration corrector using quadrupole fields according to an embodiment of the present invention.

Fig. 4 is a schematic diagram of an electrostatic quadrupole element.

Fig. 5 is a schematic diagram of a magnetic quadrupole element.

Fig. 6 is a schematic diagram of a quadrupole element in which electrostatic and magnetic fields are superimposed.

Fig. 7 is a schematic diagram of a hexapole element in which electrostatic and magnetic fields are superimposed.

DETAILED DESCRIPTION OF THE INVENTION

Embodiments of the present invention are hereinafter described with reference to the drawings.

An embodiment of the present invention which is described below is an aberration corrector incorporated in the illumination system of a transmission electron microscope. This aberration corrector in the illumination system corrects chromatic aberration in an objective lens or in a condenser lens by the use of two-fold fields (quadrupole field) produced by electrostatic multipole elements, magnetic multipole elements, or a combination of both electrostatic and magnetic multipole elements (i.e., using a superimposition of electrostatic and magnetic fields). Especially, an optical system having a focusing effect in the direction of divergence of a cylindrically symmetrical type is created by a quadrupole field having a thickness to correct chromatic aberration. This optical system may be hereinafter abbreviated as the "optical system having a concave lens effect" or simply "concave lens". In principle, the concave lens effect created by the quadrupole field having a thickness (length in the direction of motion of theelectronbeam) is employed for correctionof chromatic aberration. This is different from the method which is used in scanning electron microscopy (SEM) and which utilizes superimposition of electric and magnetic fields (see, for example, the description of the prior art in patent reference 1 (Japanese Patent Laid-Open No. 2003-203593)). That is, the present invention is characterized in that the optical system (a so-called concave lens) having a focusing effect in the direction of divergence of the cylindrically symmetrical type on a cylindrically symmetrical electron beam having spread is created by a quadrupole field having thickness. The cylindrically symmetrical electron beam having spread has neither positional anisotropy nor angular anisotropy, unlike an electron beam that is brought to a line focus.

The meaning that the multipole element has thickness (length in the direction of motion in the electron beam) is described. For example, a quadrupole element has an essential function of producing a two-fold field. A hexapole element has an essential function of producing a three-fold field. Each of these fields is referred to as the primary term in the multipole field. An actual multipole element produces fields by higher-order terms other than the primary term though the produced fields are quite weak. In a normal multipole element having no or little thickness, higher-order terms other than the primary term are neglected in applications of the multipole element or simply act as parasitic factors. However, if the thickness of the multipole element is increased, the effects of the higher-order terms other than the primary term manifest themselves. A multipole element having a length in the direction of motion of the electron beam which permits the effects of the higher-order terms to be used is necessary to correct chromatic aberration in a multipole element producing a quadrupole field and having thickness (length in the direction of motion of the electron beam).

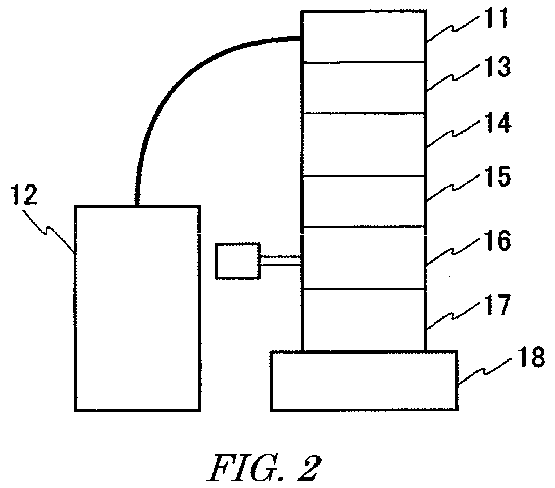

Fig. 2 is a diagram showing the structure of a transmission electron microscope having an aberration corrector in the illumination system. The microscope has an electron gun 11 using a high-voltage power supply that is controlled by a high-voltage controller 12. Under this condition, the gun 11 produces an electron beam that is converged by a condenser lens 13 including stigmatic correcting elements. The converged beam reaches the aberration corrector 14 in the illumination system. The corrector 14 has various correcting elements including electron beam-deflecting elements and multipole elements. Especially, in the present embodiment, a multipole element having thickness (length in the direction of motion of the electron beam) is used to produce a quadrupole field. Chromatic aberration is corrected by the concave lens effect produced by the quadrupole field.

The electron beam having aberrations which have been corrected by the aberration corrector 14 in the illumination system is passed through another condenser lens 15 including electron beam-deflecting elements. The beam reaches an objective lens and specimen stage 16. The objective lens causes the beam to hit a specimen placed on the specimen stage. The beam transmitted through the specimen lying on the specimen stage is projected by intermediate and projector lenses 17 and reaches an observation chamber 18, where an image of the specimen is observed. For example, the image is photographed by a camera.

The aberration corrector 14 in the illumination system uses a quadrupole field having a length in the direction of motion in the electron beam (i.e., having so-called thickness) as mentioned previously. The quadrupole field having thickness shows a concave lens action having two-fold astigmatism and cylindrical symmetry. The optical system producing the concave lens action (quadrupole field having thickness) is used for correction of chromatic aberration in the whole system produced by the objective lens or condenser lens.

It is known that if a concave lens different in refractive index from an objective lens can be fabricated, it is generally possible to correct the objective lens for chromatic aberration. The principle on which the same effect as a concave lens having a different refractive index (the dependence of the deflecting force on the accelerating voltage) is produced by a quadrupole field having thickness is described.

In a reciprocal space (focal plane), a position is given by r in terms of complex notation. Let $r'$ be a gradient. Let $\Omega$ be a complex angle. A derivative of the complex angle is given by $\Omega'$. Let $A_2$ be a coefficient of the two-fold astigmatism per unit length. A two-fold astigmatism (geometric aberration) is given by Eq. (1) using $A_2$ and the complex conjugate of $\Omega$.

$$A_2 \overline{\Omega} \qquad (1)$$

It is assumed that the two-fold astigmatism is produced by an electrostatic element, by magnetic polepieces, or by a superimposition of fields produced by both electrostatic element and magnetic polepieces. At the entrance plane in the quadrupole element, the position and the gradient of the electron beam are given by $r_0$ and $r_0'$ respectively in terms of complex notation in Eq. (2). At the exit plane in the quadrupole element, the position and the gradient of the electron beam are given by $r_1$ and $r_1'$ respectively in terms of complex notation in Eq. (3).

$$\begin{pmatrix} r_0 \\ r_0' \end{pmatrix} \qquad (2)$$

$$\begin{pmatrix} r_1 \\ r_1' \end{pmatrix} \qquad (3)$$

Let f be the focal length. The real space is taken as a specimen space. The position and the gradient in the reverse space corresponding to the real space can be written as $r = f \cdot \Omega$ and $r' = f \cdot \Omega'$. Let t be the thickness of the quadrupole field in the direction of motion of the electron beam. The gradient of the exit point caused by a thick quadrupole field can be written by Eq. (4).

$$r'_1 = r_0'$$
$$-\sum_{n=1} \frac{\overline{\Omega}_0}{(4n-3)! f^{4n-3}} A_2 \cdot |A_2|^{2(n-1)} t^{4n-3} - \sum_{n=1} \frac{\overline{\Omega}'_0}{(4n-2)! f^{4n-3}} A_2 \cdot |A_2|^{2(n-1)} t^{4n-2}$$
$$+\sum_{n=1} \frac{\Omega_0}{(4n-1)! f^{4n-1}} |A_2|^{2n} t^{4n-1} + \sum_{n=1} \frac{\Omega_0'}{(4n)! f^{4n-1}} |A_2|^{2n} t^{4n} \qquad (4)$$

where n is a positive number ($n > 0$).

In Eq. (4) above, the term having the coefficient $A_2 \cdot |A_2|^{2(n-1)}$ gives two-fold astigmatism. Meanwhile, the term $|A_2|^{2n}$ produces a lens effect having cylindrical symmetry. A term having positive sign (+) produces a concave lens action. In the present specification, the effect producing this action is referred to as "focusing action in the direction of divergence of the cylindrically symmetrical type".

Let U be the accelerating voltage. In the case of an electric quadrupole field, the strength $|A_{E2}|$ is given by Eq. (5).

$$|A_{E2}| \propto \frac{1}{U} \qquad (5)$$

In the case of a magnetic quadrupole field, the strength $|A_{B2}|$ is given by Eq. (6).

$$|A_{B2}| \propto \frac{1}{\sqrt{U}} = \frac{1}{U^{\frac{1}{2}}} \qquad (6)$$

With respect to an optical system producing a concave lens effect by means of a quadrupole field having thickness, $|A_2|$ of Eq. (4) is given by powers of $2n$ and $2(n - 1)$ and so the dependence of the deflecting force of the optical system on accelerating voltage can take a form proportional to $1/U^N$, where N ($> 0$) is an integer, by various combinations. Furthermore, even in an optical system where electric and magnetic fields are superimposed such that the trajectory of the electron beam is prevented from being varied by certain accelerating voltages, $|A_2|$ has a finite value in the trajectory of the electron beam accelerated at different accelerating voltages. Therefore, the optical system undergoes a concave lens action.

Meanwhile, let $f_0$ be the focal length of an axially symmetrical magnetic objective lens that is generally used in a transmission electron microscope. Generally, the deflecting force of this kind of lens can be written as in Eq. (7)

$$\frac{r'}{r} = \frac{1}{f_0} \propto \frac{1}{U} \qquad (7)$$

As written by Eq. (4), the dependence of the deflecting force of an optical system producing a concave lens effect on accelerating voltage assumes the form $1/U^N$ as mentioned previously, the lens effect being produced by a thick quadrupole field. This is greatly different from the form $1/U$ written by Eq. (7). Therefore, an optical system producing a concave lens action different in refractive index from the objective lens can be created using a thick quadrupole field. That is, an optical system producing a concave lens effect that is different in refractive index from the objective lens can be built. Consequently, the objective lens can be corrected for chromatic aberration.

As can be seen from Eq. (4), if the thickness of the quadrupole field (length in the direction of motion in the electron beam) is increased, the concave lens action is made stronger. Accordingly, where the quadrupole field is used for correction of chromatic aberration, the thickness t can be determined from the magnitude required for the concave lens effect. The requirements of embodiments of the present invention described so far are summarized as follows. An optical system producing a concave lens effect is created from an electrostatic quadrupole field, a magnetic quadrupole field, or a superimposition of electrostatic and magnetic quadrupole fields. The electrostatic quadrupole field or magnetic quadruple field is created using a quadrupole field-producing multipole element and has thickness (length in the direction of motion of the electron beam).

More specifically, a lens can be corrected for chromatic aberration by creating an optical system acting as a concave lens that is different in refractive index (the dependence of the deflecting force on accelerating voltage or wavelength) from the lens. The optical system is created from an electrostatic quadrupole field, a magnetic quadrupole field, or a superimposition of electrostatic and magnetic quadrupole fields. The electrostatic quadrupole field or magnetic quadrupole field has thickness.

Then, an embodiment is described in which another quadrupole field having the same thickness is prepared. A pair of transfer lenses is configured between the two quadrupole fields. The second quadrupole field is reversed in polarity from the first field. Let $r_2'$ be the gradient at the exit plane of the second field. The results of a calculation are given by Eq. (8).

$$r_2' = -2 \sum_{n=1} \frac{\Omega_0}{(4n-1)! f^{4n-1}} |A_2|^{2n} t^{4n-1}$$

$$+ \sum_{n=1} \sum_{m=1} \left\{ \frac{-16mn + 12n + 12m - 8}{(4n-2)!(4m-2)!} \right\} \frac{\Omega_0}{f^{4n+4m-5}} \cdot |A_2|^{2n+2m-2} t^{4n+4m-5}$$

$$+ \sum_{n=1} \sum_{m=1} \left\{ \frac{16mm - 4n - 4m}{(4n)!(4m)!} \right\} \frac{\Omega_0}{f^{4n+4m-1}} |A_2|^{2n+2m} t^{4n+4m-1} \tag{8}$$

where n and m are integers ($n$, m > 0).

Each term of Eq. (8) represents a lens effect. The terms have different orders for the thickness t. Thus, it can be seen that the term having the coefficient $A_2 \cdot |A_2|^{2(n-1)}$ indicating two-fold astigmatism within Eq. (4) has been canceled out in Eq. (8).

That is, the term of two-fold astigmatism that is unnecessary for aberration correction is canceled out by using two quadrupole fields and setting them to mutually opposite polarities. The cylindrically symmetrical effect necessary for the aberration correction alone can be extracted.

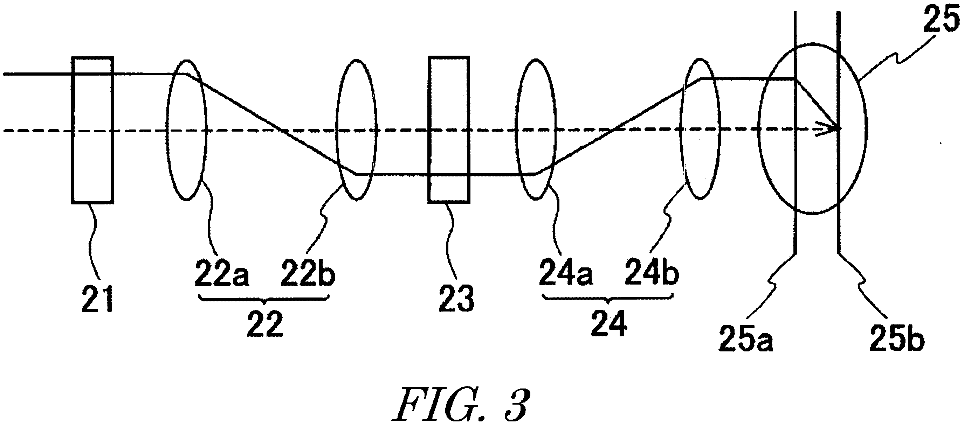

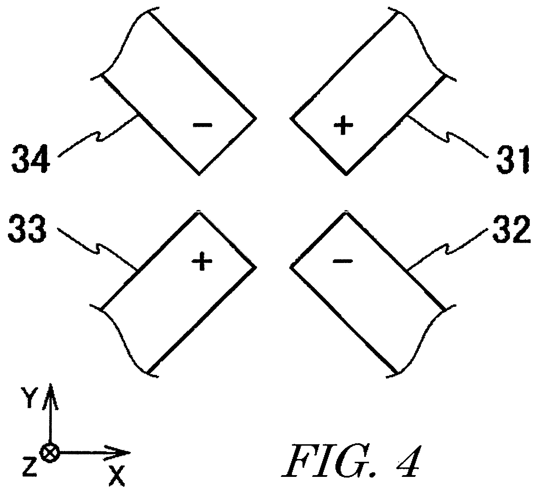

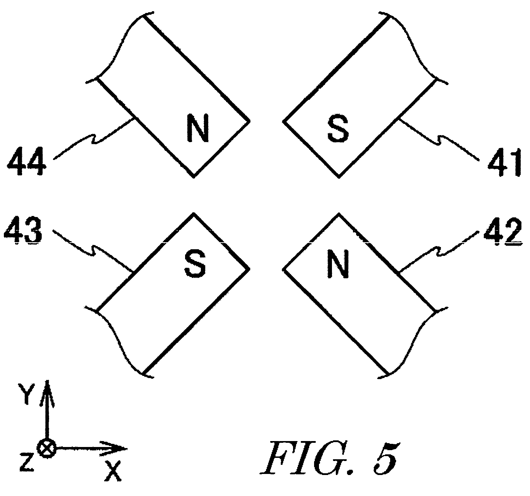

Fig. 3 is a diagram showing the optical system of an aberration corrector using two quadrupole field-producing multipole elements having thickness. An electrostatic quadrupole field or a magnetic quadrupole field can be used as each quadrupole field-producing multipole element. Both electrostatic and magnetic quadrupole fields can be used. Two electrostatic quadrupole elements may be used. Furthermore, two magnetic quadrupole elements may be used. Specific examples of the configurations of these electrostatic and magnetic quadrupole fields are described later by referring to Figs. 4 and 5.

The configuration of Fig. 3 is an example in which chromatic aberration produced in an objective lens 25 is corrected by using two quadrupolefield-producing multipole elements having thickness. A coma-free surface 25a and a specimen surface 25b are formed on the obj ective lens 25. The coma-free surface 25a is substantially coincident with the front focal plane. Each of a first quadrupole field-producing multipole element 21 and a second quadrupole field-producing multipole element 23 has thickness (length in the direction of motion of the electron beam).

If chromatic aberration is produced in the first quadrupole field-producing multipole element 21, surplus two-fold astigmatism may remain. The two-fold astigmatism is removed by inserting the second quadrupole field-producing multipole element 23 such as a second quadrupole field. The second quadrupole field-producing multipole element 23 is reversed in polarity from the first multipole element 21.

Furthermore, as shown in Fig. 3, a transfer lens pair consisting of lenses 22a and 22b is inserted between the first quadrupole field-producing multipole element 21 and the second quadrupole field-producing element 23. In addition, a transfer lens pair consisting of lenses 24a and 24b is inserted between the second quadrupole field-producing multipole element 23 and the objective lens 25.

The transfer lenses which are unnecessary in the aberration-correcting optical systemof SEM are used in the chromatic aberration-correcting optical system of the present embodiment for the following reason. As already described in connection with Fig. 1, in correcting chromatic aberration in TEM, the electron beam spreading over the whole field of view (i.e., cylindrically symmetrical electron beam having spread) needs to be corrected uniformly. For this purpose, the electron beam should be deflected only in a space that does not depend on the position of the beam. Consequently, the multipole elements need to act totally in a reverse space. Furthermore, electrons need to be transferred between the multipole elements through the reverse space using the transfer lenses. That is, by using the transfer lenses 22 and 24 together with the first and second quadrupole field-producing multipole elements 21 and 23, the aberration corrector having the optical system shown in Fig. 3 can correct the cylindrically symmetrical electron beam having spread for chromatic aberration with a relatively simple correction system. Where embodiments of the present invention are used for correction of chromatic aberration in the optical system in STEM mode of TEM or in SEM, transfer lenses are not always necessary.

In order to correct chromatic aberration by an optical system producing a concave lens effect by means of two quadrupole fields, the following configuration can be created. Two electrostatic quadrupole fields having thickness are placed as an optical system for correcting chromatic aberration to prevent two-fold astigmatism frombeing left behind. Furthermore, two magnetic quadrupole fields having thickness may be placed as the optical system for correcting chromatic aberration to prevent two-fold astigmatism from being left behind. Additionally, two quadrupole fields in each of which an electrostatic quadrupole field and a magnetic quadrupole field, both having thickness, are superimposed may be placed as the optical system for correcting chromatic aberration to prevent two-fold astigmatism from being left behind. Moreover, a pair of transfer lenses may be placed between two electrostatic quadrupole fields having thickness. Further, a pair of transfer lenses may be placed between two magnetic quadrupole fields having thickness. Yet further, a pair of transfer lenses may be placed between two quadrupole fields in each of which an electrostatic quadrupole field and a magnetic quadrupole field, both having thickness, are superimposed. Still further, a pair of transfer lenses may be placed between the aforementioned second quadrupole field-producing multipole elements and the objective lens.

The principle on which chromatic aberration can be corrected using an optical system is described, the optical system producing a concave lens effect by means of quadrupole fields which are identical in refractive index with the objective lens.

Generally, chromatic aberration coefficient $C_c$ is given by Eq. (9).

$$Cc = U\left(\frac{df}{dU}\right) \qquad (9)$$

Let $K$ be a proportional coefficient. If a concave lens of Eq. (8) given by a formula $f = -K \cdot U$ can be created, we have $C_c = U \cdot (-K) = f$. The chromatic aberration and focal length become equal in value. On the other hand, the chromatic aberration coefficient $C_{co}$ of the objective lens generally satisfies the relationship $f_0 > C_{co}$, where $f_0$ is the focal length. That is, the chromatic aberration coefficient is smaller than the focal distance. Even if a system satisfying the relationship $f_0 > f$ is created in order to focus the beam using a concave lens that is identical in refractive index with the objective lens, the chromatic aberration can be finally reduced down to $f_0 - f$ by correcting the chromatic aberration produced in the whole objective lens by the chromatic aberration produced by the concave lens.

That is, a concave lens is created by an electrostatic quadrupole field having thickness. If the concave lens is identical in refractive index with the objective lens, chromatic aberration can be corrected by making use of the fact that the absolute value of a negative amount of chromatic aberration of the concave lens is greater than the amount of chromatic aberration of the objective lens. Furthermore, chromatic aberration of the objective lens can be corrected by creating a concave lens by means of a magnetic quadrupole field having thickness and, if the concave lens is identical in refractive index with the objective lens, by making use of the fact that the absolute value of a negative amount of chromatic aberration is greater than the amount of chromatic aberration of the objective lens.

Of course, it is also possible to create a concave lens by superimposing an electrostatic quadrupole field and a magnetic quadrupole field having thickness, even if the concave lens is identical in refractive index with the objective lens, and by making use of the fact that the absolute value of a negative amount of chromatic aberration of the concave lens is greater than the amount of chromatic aberration of the objective lens.

The electron optical system of a transmission electron microscope can be corrected for chromatic aberration, using an optical system acting as a concave lens which is produced by quadrupole fields and which is identical in refractive index with the objective lens.

The optical system of embodiments of the present invention capable of correcting chromatic aberration canbe modified as follows. Two electrostatic quadrupole field-producing multipole elements having different thicknesses (lengths in the direction of motion of the electron beam) may be used. Alternatively, two magnetic quadrupole field-producing multipole elements having different thicknesses (lengths in the direction of motion of the electron beam) may be used. In addition, two multipole elements which are different in thickness and in each of which an electrostatic quadrupole field and a magnetic quadrupole field are superimposed may be used.

A quadrupole element produces a two-fold field. Further examples of quadrupole field-producing multipole element for producing a two-fold field for implementing embodiments of the present invention are as follows: a hexapole element on which a quadrupole field is superimposed to produce an electrostatic or electric two-fold field; a dodecapole (12-pole) element on which a quadrupole field is superimposed to produce an electrostatic or electric two-fold field; and an octopole element on which a quadrupole field is superimposed to produce an electrostatic or electric two-fold field.

Figs. 4-7 show the configurations of the aforementioned electrostatic quadrupole element, magnetic quadrupole element, electrostatic field-magnetic field superimposed quadrupole element, and electrostatic field-magnetic field superimposed hexapole element, respectively.

Fig. 4 is a schematic diagram of the electrostatic quadrupole element. In this configuration, a positive pole 31, a negative pole 32, a positive pole 33, and a negative pole 34 forming an electrostatic quadrupole element are arranged on the xy-plane perpendicular to the direction of motion z of the electron beam. Each pole has thickness in the direction of motion z of the electron beam.

Fig. 5 is a schematic diagram of the magnetic quadrupole element. An S-pole 41, an N-pole 42, an S-pole 43, and an N-pole 44 forming the magnetic quadrupole element are arranged on the xy-plane perpendicular to the direction of motion z of the electron beam. Each pole has thickness in the direction of motion z of the electron beam.

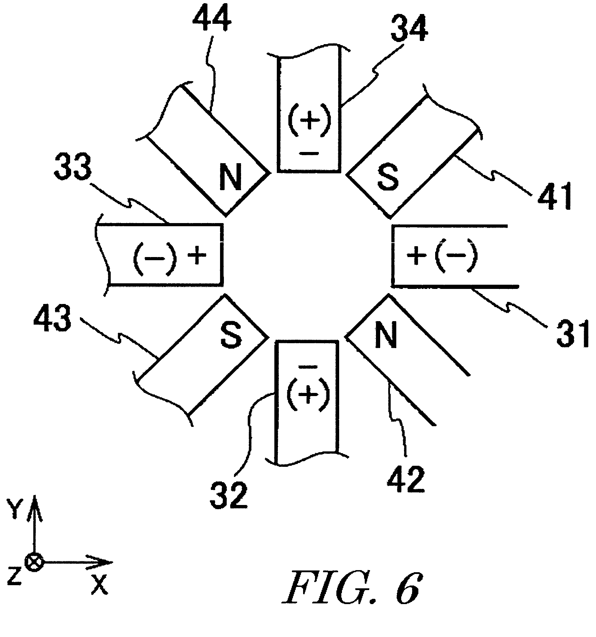

Fig. 6 is a schematic diagram of the electrostatic field-magnetic field superimposed quadrupole element. An S-pole 41, a positive pole 31, an N-pole 42, a negative pole 32, an S-pole 43, a positive pole 33, an N-pole 44, and a negative pole 34 are arranged on the xy-plane perpendicular to the direction of motion z of the electron beam. Each pole has thickness in the direction of motion z of the electron beam.

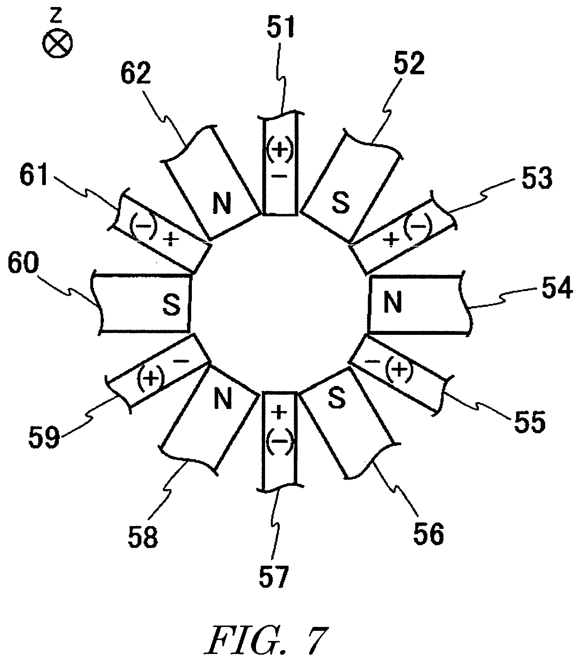

Fig. 7 is a schematic diagram of the electrostatic field-magnetic field superimposed hexapole element. A negative pole 51, an S-pole 52, a positive pole 53, an N-pole 54, a negative pole 55, an S-pole 56, a positive pole 57, an N-pole 58, a negative pole 59, an S-pole 60, a positive pole 61, and an N-pole 62 are arranged on the xy-plane perpendicular to the direction of motion z of the electron beam. Each pole has thickness in the direction of motion z of the electron beam.

Fig. 3 shows a specific example of the configuration of an aberration corrector. In Fig. 3, two quadrupole field-producing multipole elements 21 and 23 are used.

In the description of the above embodiments of the present invention, correction of chromatic aberration in an illumination system for forming a probe to be directed to a specimen is taken as an example. The invention can also be applied to correction of chromatic aberration in an imaging system.

Embodiments of the present invention are intended to correct a lens for an aberration for a cylindrically symmetrical electron beam having spread. The cylindrically symmetrical electron beam is not always required to have a cross section that is circular when hitting the specimen. Obviously, embodiments of the present invention can also be applied to the case where the cross section of an electron beam is shaped into a noncircular form using a rectangular slit or the like.

## Claims

1. An aberration corrector (14) for correcting aberration produced in a lens (25) disposed in the direction of motion of a spreading electron beam which is cylindrically symmetrical, said aberration corrector comprising:

   a first quadrupole field-producing multipole element (21) on which the electron beam not yet corrected for the aberration impinges, the first quadrupole field-producing multipole element producing a first quadrupole field; and
   a second quadrupole field-producing multipole element (23) from which the electron beam corrected for the aberration exits, the second quadrupole field-producing multipole element producing a second quadrupole field;

   wherein each of said first and second quadrupole fields produces an optical system having a two-fold astigmatism and a concave lens effect having cylindrical symmetry, said concave lens effect being produced by higher-order terms of the quadrupole field which have magnitudes increasing at higher rates than the primary term when the length in the direction of motion of the electron beam is increased; and
   wherein said first and second quadrupole fields are set to mutually opposite polarities, whereby the two-fold astigmatism of the first and second quadrupole fields on the cylindrically symmetrical spreading electron beam are canceled out and only the concave lens effect is used for correction of the aberration in the lens.

2. An aberration corrector (14) as set forth in any one of claim 1, wherein the aberration in the lens (25) corrected by using a combination of said first and second quadrupole field-producing multipole elements (21, 23) is chromatic aberration.

3. An aberration corrector (14) as set forth in any one of claims 1 to 2, wherein said quadrupole field produced by each of said quadrupole field-producing multipole elements (21, 23) is any one of an electrostatic quadrupole field, a magnetic quadrupole field, and a quadrupole field obtained by superimposing an electrostatic quadrupole field and a magnetic quadrupole field.

4. An aberration corrector (14) as set forth in any one of claims 1 to 3, wherein a pair of transfer lenses (22a, 22b) is disposed between the two quadrupole field-producing multipole elements (21, 23).

5. An aberration corrector (14) as set forth in any one of claims 1 to 4, wherein the quadrupole fields produced respectively by the two quadrupole field-producing multipole elements (21, 23) are different in length taken in the direction of motion of the electron beam.

6. An aberration corrector (14) as set forth in any one of claims 1 to 5, wherein each of said quadrupole field-producing multipole elements (21, 23) is a hexapole element which uses an electrostatic field, a magnetic field, or both and on which a quadrupole field is superimposed such that the hexapole element acts to produce an electrostatic field or an electric two-fold field.

7. An aberration corrector (14) as set forth in any one of claims 1 to 5, wherein each of said quadrupole field-producing multipole elements (21, 23) is a dodecapole element which uses an electrostatic field, a magnetic field, or both and on which a quadrupole field is superimposed such that the dodecapole element acts to produce an electrostatic field or an electric two-fold field.

8. An aberration corrector (14) as set forth in any one of claims 1 to 5, wherein each of said quadrupole field-producing multipole elements (21, 23) is an octopole element which uses an electrostatic field, a magnetic field, or both and on which a quadrupole field is superimposed such that the octopole element acts to produce an electrostatic field or an electric two-fold field.

9. An aberration corrector (14) as set forth in any one of claims 1 to 8, wherein a pair of transfer lenses (24a, 24b) is disposed between said second quadrupole field-producing multipole element and the objective lens.

10. A method of correcting aberration produced in a lens (25) disposed in the direction of motion of an electron beam, said method comprising the steps of:

preparing two multipole elements (21, 23) each producing a quadrupole field having a length in the direction of motion of the electron beam;
causing each of the multipole elements to produce a two-fold astigmatism and a concave lens effect having cylindrical symmetry, said two-fold astigmatism increasing in magnitude as the length of the quadrupole field in the direction of motion of the beam is increased, said concave lens effect being produced by higher-order terms of the quadrupole field; and
combining the two quadrupole fields produced by the multipole elements such that the two-fold astigmatism produced by the two quadrupole fields are canceled out, whereby only the concave lens effects are used to correct the lens for the aberration for the cylindrically symmetrical spreading electron beam.

11. A method of correcting aberration as set forth in claim 10, wherein said lens (25) is corrected for chromatic aberration by causing the quadrupole field-producing multipole elements (21, 23) to produce the quadrupole fields having lengths in the direction of motion of the electron beam to create an optical system which produces the concave lens effect and which is different in refractive index from the lens.

12. A method of correcting aberration as set forth in claim 10, wherein said lens (25) is corrected for chromatic aberration by causing the quadrupole field-producing multipole elements (21,23) to produce the quadrupole fields having lengths in the direction of motion of the electron beam to create an optical system which produces the concave lens effect and by making use of the fact that the absolute value of a negative amount of chromatic aberration of the optical system is greater than the amount of chromatic aberration in the lens if the optical system is identical in refractive index with the lens.

**Patentansprüche**

1. Aberrationskorrekturvorrichtung (14) zum Korrigieren einer Aberration, die in einer Linse (25) erzeugt wird, die in Bewegungsrichtung eines sich ausbreitenden zylindersymmetrischen Elektronenstrahls angeordnet ist, wobei die Aberrationskorrekturvorrichtung aufweist:

ein erstes ein Quadrupolfeld erzeugendes Multipolelement (21) auf das der noch nicht bezüglich der Aberration korrigierte Elektronenstrahl auftrifft, wobei das erste ein Quadrupolfeld erzeugende Multipolelement ein erstes Quadrupolfeld erzeugt, und

ein zweites ein Quadrupolfeld erzeugendes Multipolelement (23), aus dem der bezüglich der Aberration korrigierte Elektronenstrahl austritt, wobei das zweite ein Quadrupolfeld erzeugende Multipolelement ein zweites Quadrupolfeld erzeugt,

wobei das erste und das zweite Quadrupolfeld jeweils ein optisches System erzeugen, das einen Zweifachastigmatismus und einen Konkavlinseneffekt mit zylindrischer Symmetrie aufweist,

wobei der Konkavlinseneffekt durch Terme höherer Ordnung des Quadrupolfeldes erzeugt wird, deren Größen schneller zunehmen als der Grundterm, wenn die Länge in Bewegungsrichtung des Elektronenstrahls zunimmt, und

wobei die Polaritäten des ersten und des zweiten Quadrupolfelds einander entgegengesetzt eingestellt sind und der zweifache Astigmatismus des ersten und des zweiten Quadrupolfelds auf dem sich ausbreitenden zylindersymmetrischen Elektronenstrahl einander aufheben und lediglich der Kokavlinseneffekt zur Korrektur der Linsenaberration genutzt wird.

2. Aberrationskorrekturvorrichtung (14) nach Anspruch 1, wobei die unter Verwendung einer Kombination des ersten und des zweiten jeweils ein Quadrupolfeld erzeugenden Multipolelements (21, 23) korrigierte Aberration der Linse (25) eine chromatische Aberration ist.

3. Aberrationskorrekturvorrichtung (14) nach Anspruch 1 oder 2, worin das von dem jeweiligen ein Quadrupolfeld erzeugendenden Multipolelement (21, 23) erzeugte Quadrupolfeld ein elektrostatisches Quadrupolfeld, ein magnetisches Quadrupolfeld oder ein Quadrupolfeld ist, das durch Überlagerung eines elektrischen Quadrupolfeldes mit einem magnetischen Quadrupolfeld erhalten wird.

4. Aberrationskorrekturvorrichtung (14) nach einem der Ansprüche 1 bis 3, wobei zwischen den beiden ein Quadrupolfeld erzeugendenden Multipolelementen (21, 23) zwei Transferlinsen (22a, 22b) angeordnet sind.

5. Aberrationskorrekturvorrichtung (14) nach einem der Ansprüche 1 bis 4, wobei die von den beiden ein Quadrupolfeld erzeugendenden Multipolelementen (21, 23) jeweils erzeugten Quadrupolfelder in der Bewegungsrichtung des Elektronenstrahls unterschiedlich lang sind.

6. Aberrationskorrekturvorrichtung (14) nach einem der Ansprüche 1 bis 5, wobei jedes der ein Quadrupolfeld erzeugendenden Multipolelemente (21, 23) ein Hexapolelement ist, das ein elektrostatisches Feld, ein magnetisches Feld oder beide verwendet und dem ein Quadrupolfeld so überlagert ist, dass das Hexapolelement so wirkt, dass ein elektrostatisches Feld oder ein elektrisches Zweifachfeld gebildet wird.

7. Aberrationskorrekturvorrichtung (14) nach einem der Ansprüche 1 bis 5, wobei jedes der ein Quadrupolfeld erzeugendenden Multipolelemente (21, 23) ein Dodecapolelement ist, das ein elektrostatisches Feld, ein magnetisches Feld oder beide verwendet und dem ein Quadrupolfeld so überlagert ist, dass das Dodecapolelement so wirkt, dass ein elektrostatisches Feld oder ein elektrisches Zweifachfeld gebildet wird.

8. Aberrationskorrekturvorrichtung (14) nach einem der Ansprüche 1 bis 5, wobei jedes der ein Quadrupolfeld erzeugendenden Multipolelemente (21, 23) ein Octopolelement ist, das ein elektrostatisches Feld, ein magnetisches Feld oder beide verwendet und dem ein Quadrupolfeld so überlagert ist, dass das Octopolelement so wirkt, dass ein elektrostatisches Feld oder ein elektrisches Zweifachfeld gebildet wird.

9. Aberrationskorrekturvorrichtung (14) nach einem der Ansprüche 1 bis 8, wobei zwischen dem zweiten ein Quadrupolfeld erzeugendenden Multipolelement und der Objektivlinse zwei Transferlinsen (24a, 24b) angeordnet sind.

10. Verfahren zum Korrigieren einer Aberration, die in einer Linse (25) erzeugt wird, die in Bewegungsrichtung eines Elektronenstrahls angeordnet ist, wobei das Verfahren Schritte umfasst zum:

Herrichten von zwei Multipolelementen (21, 23), von denen jedes ein Quadrupolfeld mit einer sich in Bewegungsrichtung des Elektronenstrahls erstreckenden Länge erzeugt;

Bewirken, dass jedes der Multipolelemente einen Zweifachastigmatismus und einen Konkavlinseneffekt mit zylindrischer Symmetrie erzeugt, wobei das Ausmaß des Zweifachastigmatismus zunimmt, wenn die Länge des Quadrupolfelds in Bewegungsrichtung des Strahls zunimmt, und wobei der Konkavlinseneffekt durch Terme höherer Ordnung des Quadrupolfeldes erzeugt wird, und

Kombinieren der beiden von den Multipolelementen erzeugten Quadrupolfelder so, dass sich der von den beiden Quadrupolfeldern erzeugte Zweifachastigmatismus aufhebt, wodurch lediglich der Kokavlinseneffekt zur Korrektur der Linsenaberration für den sich zylindersymmetrisch ausbreitenden Elektronenstrahl verwendet wird.

**11.** Verfahren zum Korrigieren einer Aberration nach Anspruch 10, worin eine chromatische Aberration der Linse (25) korrigiert wird, indem bewirkt wird, dass die ein Quadrupolfeld erzeugenden Multipolelemente (21, 23) die Quadrupolfelder mit solchen Längen in Bewegungsrichtung des Elektronenstrahls erzeugen, dass ein optisches System geschaffen wird, das den Konkavlinseneffekt erzeugt und einen von der Linse verschiedenen Brechungsindex aufweist.

**12.** Verfahren zum Korrigieren einer Aberration nach Anspruch 10, worin eine chromatische Aberration der Linse (25) korrigiert wird, indem bewirkt wird, dass die ein Quadrupolfeld erzeugenden Multipolelemente (21, 23) die Quadrupolfelder mit solchen Längen in Bewegungsrichtung des Elektronenstrahls erzeugen, dass ein optisches System geschaffen wird, das den Konkavlinseneffekt erzeugt, und in dem von der Tatsache Gebrauch gemacht wird, dass der Absolutwert eines negativen Werts der chromatischen Aberration des optischen Systems größer als der Wert der chromatischen Aberration der Linse ist, wenn der Brechungsindex des optischen Systems gleich dem der Linse ist.

**Revendications**

**1.** Correcteur d'aberration (14) pour corriger une aberration produite dans une lentille (25) disposée dans la direction de déplacement d'un faisceau d'électrons d'étalement qui est de symétrie cylindrique, ledit correcteur d'aberration comprenant :

un premier élément multipolaire de production de champ quadripolaire (21) sur lequel le faisceau d'électrons dont l'aberration n'a pas encore été corrigée arrive, le premier élément multipolaire de production de champ quadripolaire produisant un premier champ quadripolaire ; et
un deuxième élément multipolaire de production de champ quadripolaire (23) à partir duquel le faisceau d'électrons dont l'aberration est corrigée sort, le deuxième élément multipolaire de production de champ quadripolaire produisant un deuxième champ quadripolaire ;

dans lequel chacun desdits premier et deuxième champs quadripolaires produit un système optique ayant un astigmatisme d'ordre deux et un effet de lentille concave ayant une symétrie cylindrique,
ledit effet de lentille concave étant produit par des termes d'ordre supérieur du champ quadripolaire qui ont des amplitudes augmentant à des taux plus élevés que le terme primaire lorsque la longueur dans la direction de déplacement du faisceau d'électrons augmente ; et
dans lequel lesdits premier et deuxième champs quadripolaires sont réglés à des polarités mutuellement opposées, moyennant quoi les astigmatismes d'ordre deux des premier et deuxième champs quadripolaires sur le faisceau d'électrons d'étalement à symétrie cylindrique sont neutralisés et seulement l'effet de lentille concave est utilisé pour la correction de l'aberration dans la lentille.

**2.** Correcteur d'aberration (14) selon la revendication 1, dans lequel l'aberration dans la lentille (25) corrigée en utilisant une combinaison desdits premier et deuxième éléments multipolaires de production de champs quadripolaires (21, 23) est une aberration chromatique.

**3.** Correcteur d'aberration (14) selon l'une quelconque des revendications 1 à 2, dans lequel ledit champ quadripolaire produit par chacun desdits éléments multipolaires de production de champs quadripolaires (21, 23) est un champ quelconque parmi un champ électrostatique quadripolaire, un champ magnétique quadripolaire, et un champ quadripolaire obtenu en superposant un champ électrostatique quadripolaire et un champ magnétique quadripolaire.

**4.** Correcteur d'aberration (14) selon l'une quelconque des revendications 1 à 3, dans lequel une paire de lentilles de transfert (22a, 22b) est disposée entre les deux éléments multipolaires de production de champs quadripolaires (21, 23).

**5.** Correcteur d'aberration (14) selon l'une quelconque des revendications 1 à 4, dans lequel les champs quadripolaires produits respectivement par les deux éléments multipolaires de production de champs quadripolaires (21, 23) ont des longueurs différentes prises dans la direction de déplacement du faisceau d'électrons.

**6.** Correcteur d'aberration (14) selon l'une quelconque des revendications 1 à 5, dans lequel chacun desdits éléments multipolaires de production de champs quadripolaires (21, 23) est un élément hexapolaire qui utilise un champ électrostatique, un champ magnétique, ou les deux, et sur lequel un champ quadripolaire est superposé de sorte que l'élément hexapolaire agisse pour produire un champ électrostatique ou un champ électrique d'ordre deux.

**7.** Correcteur d'aberration (14) selon l'une quelconque des revendications 1 à 5, dans lequel chacun desdits éléments multipolaires de production de champs quadripolaires (21, 23) est un élément dodécapolaire qui utilise un champ électrostatique, un champ magnétique, ou les deux et sur lequel un champ quadripolaire est superposé de sorte que l'élément dodécapolaire agisse pour produire un champ électrostatique ou un champ électrique d'ordre deux.

**8.** Correcteur d'aberration (14) selon l'une quelconque des revendications 1 à 5, dans lequel chacun desdits éléments multipolaires de production de champs quadripolaires (21, 23) est un élément octopolaire qui utilise un champ électrostatique, un champ magnétique, ou les deux et sur lequel un champ quadripolaire est superposé de sorte que l'élément octopolaire agisse pour produire un champ électrostatique ou un champ électrique d'ordre deux.

**9.** Correcteur d'aberration (14) selon l'une quelconque des revendications 1 à 8, dans lequel une paire de lentilles de transfert (24a, 24b) est disposée entre ledit deuxième élément multipolaire de production de champ quadripolaire et la lentille de focalisation.

**10.** Procédé de correction d'aberration produite dans une lentille (25) disposée dans la direction de déplacement d'un faisceau d'électrons, ledit procédé comprenant les étapes qui consistent :

à préparer deux éléments multipolaires (21, 23), chacun produisant un champ quadripolaire ayant une longueur dans la direction de déplacement du faisceau d'électrons ;
à amener chacun des éléments multipolaires à produire un astigmatisme d'ordre deux et un effet de lentille concave ayant une symétrie cylindrique, l'amplitude dudit astigmatisme d'ordre deux augmente à mesure que la longueur du champ quadripolaire dans la direction de déplacement du faisceau augmente, ledit effet de lentille concave étant produit par des termes d'ordre supérieur du champ quadripolaire ; et
à combiner les deux champs quadripolaires produits par les éléments multipolaires de sorte que les astigmatismes d'ordre deux produits par les deux champs quadripolaires soient neutralisés, moyennant quoi seulement les effets de lentille concave sont utilisés pour corriger l'aberration dans la lentille pour le faisceau d'électrons d'étalement à symétrie cylindrique.

**11.** Procédé de correction d'aberration selon la revendication 10, dans lequel l'aberration chromatique dans ladite lentille (25) est corrigée en amenant les éléments multipolaires de production de champs quadripolaires (21, 23) à produire les champs quadripolaires ayant des longueurs dans la direction de déplacement du faisceau d'électrons pour créer un système optique qui produit l'effet de lentille concave et qui a un indice de réfraction différent de celui de la lentille.

**12.** Procédé de correction d'aberration selon la revendication 10, dans lequel l'aberration chromatique dans ladite lentille (25) est corrigée en amenant les éléments multipolaires de production de champs quadripolaires (21, 23) à produire les champs quadripolaires ayant des longueurs dans la direction de déplacement du faisceau d'électrons pour créer un système optique qui produit l'effet de lentille concave et en partant du fait que la valeur absolue d'une quantité négative de l'aberration chromatique du système optique est supérieure à la quantité d'aberration chromatique dans la lentille si le système optique a un indice de réfraction identique à celui de la lentille.

*FIG. 1*

*FIG. 2*

*FIG. 3*

EP 1 914 785 B1

FIG. 4

FIG. 5

EP 1 914 785 B1

FIG. 6

19

*FIG. 7*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003203593 A

- JP 2005353429 A

**Non-patent literature cited in the description**

- **O. SCHERZER.** *Optik,* 1947, vol. 2, 114-132